# EUROPEAN PATENT SPECIFICATION

(11) **EP 2 178 353 B1**
(45) Date of publication and mention of the grant of the patent: **29.02.2012**
(21) Application number: 07792301.9
(22) Date of filing: 09.08.2007
(51) Int. Cl.: H05K 3/28, H05K 1/11

(54) **CIRCUIT MODULE, AND ELECTRONIC DEVICE USING THE MODULE**
SCHALTUNGSMODUL UND DAS MODUL VERWENDENDE ELEKTRONISCHE EINRICHTUNG
MODULE DE CIRCUIT ET DISPOSITIF ÉLECTRONIQUE UTILISANT LE MODULE

(43) Date of publication of application: 21.04.2010
(73) Proprietor: Panasonic Corporation, Kadoma-shi Osaka 571-8501 (JP)
(72) Inventor: INOUE, Katsuhiro, Osaka 540-6207 (JP); SASAKI Satoshi, Osaka 540-6207 (JP)
(74) Representative: Grünecker, Kinkeldey, Stockmair & Schwanhäusser
(86) International application number: PCT/JP2007/065651
(87) International publication number: WO 2009/019792

(56) References cited:
- JP-A- 08 046 092
- JP-A- 11 345 916
- JP-A- 11 345 916
- US-A- 3 885 304

## Description

### TECHNICAL FIELD

The present invention relates to a circuit module and an electronic equipment using the same, and more particularly to a circuit board in which a plurality of electronic parts are mounted on (attached to) a board on which a circuit pattern comprising wiring conductors is formed, and a frame body is mounted on a substrate in surrounding relation to each electronic part and also to an electronic equipment (having portability), such as a portable phone and a portable communication terminal, using the same.

### BACKGROUND ART

A circuit board used in a portable terminal such as a portable phone comprises a substrate on which a circuit pattern is formed, and a plurality of electronic parts mounted such that terminal portions thereof are fixed to the circuit pattern through solder.

Also, in recent years, in such a circuit board, there has been proposed a structure in which by providing a reinforcing frame which covers the periphery and upper surface of an IC package and can be filled with a resin, the IC package is fixed to a motherboard against dropping without forming the whole into a large size, and separation of soldered portions due to a mechanical load such as impact vibration is prevented (Patent Literature 1).

In the above structure, the resin can be filled relative to a solder ball at a lower surface of the package (to be connected to the motherboard) from all sides of the periphery, and therefore the resin is directly filled and sealed in the connecting portion between the solder ball and the motherboard at which a defective connection due to separation becomes a problem in the BGA type IC package.

In the above structure, the viscosity of the resin which can be used is limited, and unless the resin has a certain degree of viscosity, the flowing of the resin from a resin pouring hole is incurred, which becomes the cause of flashes. On the other hand, when the viscosity is high, smoothness after curing is lowered, and there is encountered a problem that the appearance becomes poor.

Also, as a module structure in which a bottom surface is formed by a metal sheet, and a side surface and an upper surface are formed by a resin, and a silicone gel is filled in the interior, a module as shown in Fig. 17 has been proposed (Patent Literature 2).

In the module structure of Patent Literature 2, the gel 1014 is filled in a container surrounded by a copper base 1001 and a resin case 1009, and a resin lid 1013 is formed above the gel 104 through an air layer 1015 so as to correspond to the resin case 1009. Here, a groove is formed at the resin case 1009 and the resin lid 1013, and a sealing resin 1017 is filled in this groove to thereby form a sealing structure. This resin case 1009 has a turned-back portion 1016 at its upper end, and this turned-back portion 1016 and the resin lid 1013 are fixedly secured to each other by the sealing resin 1017. With this construction, it is contended that there can be provided the structure in which the generation of bubbles from the gel 1014 can be suppressed, and it can be filled in a manner to efficiently enter clearances, and the structure can withstand stresses due to expansion and contraction of the gel.

Patent Literature 1: JP-B-3241669
Patent Literature 2: JP-A-8-167677
Patent document JP 11 345 916 (cf. the preamble of claim 1) discloses a circuit module capable of stably protecting electronic part elements, even when vibration from the external is applied to a resin protection film encapsulated in a frame. The circuit module is constituted so that electronic parts 11 1 connected to a prescribed wiring conductor formed on a circuit board 1 and electronic part elements hidden by a resin protection film 3 charged in the frame 2 arranged on the circuit board 1 are arranged on the circuit board 1. Dividing/separating walls 24a, 24b for dividing the inside of the frame 2 into plural areas A to C are formed in the frame 2, and the electronic part element is arranged at least one (A) of the divided areas A to C.

### DISCLOSURE OF THE INVENTION

### PROBLEM THAT THE INVENTION IS TO SOLVE

However, a demand for the compact design and thin design of electronic equipments such as a portable phone is becoming increasingly high, and the structures of the above Patent Literatures 1 and 2 had their limits when achieving the thin design while maintaining the mechanical strength.

Furthermore, in a portable terminal such a portable phone, a display screen of liquid crystal or others is mounted on a circuit module, and therefore smoothness of the surface of the circuit module has been required. Particularly when liquid crystal is used in the display screen, there is encountered a problem that irregularities on a substrate contact a liquid crystal-sealing glass, and this causes a crack or invites the deterioration of a display quality. Also, in the case where a lid member was put on a circuit module, and liquid crystal was located via the lid member, a convex portion on a surface of a resin portion of the circuit module sometimes contacted the lid member to be destroyed, so that a crack developed.

The present invention has been made in view of the above circumstances, and its object is to provide a circuit module which is high in mechanical strength, and is of the thin type, and is high in reliability.

Also, it is an object of the present invention to provide a circuit module having a resin-sealed surface with a high surface smoothness.

### MEANS FOR SOLVING THE PROBLEM

The above mentioned objects are achieved by the teaching of the independent claim 1.

In this construction, two surfaces of the resin and the turned-back portion are joined together, so that the joining strength increases, and there can be provided the circuit board which is of the thin type and has a high strength.

In this construction, a cavity within the turned-back portion (within a U-shaped portion), which is due to expansion of residual gas, can be eliminated, and besides the development of a convex portion formed on the upper surface of the resin by a cavity formed in the resin by gas moved from the interior of the turned-back portion into the resin and also the development of a crater-like irregularity portion formed on the upper surface of the resin portion when gas within the frame passes to the upper surface of the resin can be suppressed, and the smooth surface can be obtained.

Further, there is provided an examplary circuit module comprising a circuit board; a plurality of electronic parts mounted on one face of the circuit board; a tubular body provided in an upstanding manner on the face so as to surround the electronic parts so that a first tube end face is joined to the face; a turned-back portion which is provided at an end of the tubular body opposite from the first tube end face, and has a first surface extending continuously from an inner surface of the tubular body at a predetermined angle relative to the inner surface and a second surface opposite to the first surface; and a resin portion formed by a resin which is filled in the tubular body until the resin reaches a distal end of the turned-back portion so as to cover at least part of the electronic parts.

In this construction, the resin is joined to the inner surface of the tubular body, the first surface of the turned-back portion, the distal end of the turned-back portion and part of the second surface of the turned-back portion, and therefore the joining strength increases, and there can be provided the circuit board which is of the thin type and has a high strength.

Furthermore, the tubular body is provided in an upstanding manner on the face of the circuit board by joining the first tube end face to the face of the circuit board, and therefore an occupied area can be increased, and an electronic part-mounting area can be increased to a larger size.

Further, there is provided an examplary circuit module comprising a circuit board; a plurality of electronic parts mounted on one face of the circuit board; a tubular body provided in an upstanding manner on the face so as to surround the electronic parts so that an inner surface of the tubular body is jointed to a region of the face spaced a predetermined distance from a first tube end face of the tubular body; a turned-back portion which is provided at an end of the tubular body opposite from the first tube end face, and has a first surface extending continuously from an inner surface of the tubular body at a predetermined angle relative to the inner surface and a second surface opposite to the first surface; and a resin portion formed by a resin which is filled in the tubular body to reach a distal end of the turned-back portion so as to cover at least part of the electronic parts.

In this construction, the resin is joined to the inner surface of the tubular body, the first surface of the turned-back portion, the distal end of the turned-back portion and part of the second surface of the turned-back portion, and therefore the joining strength increases, and there can be provided the circuit board which is of the thin type and has the high strength.

Furthermore, the tubular body is provided in an upstanding manner on the face such that the inner surface is jointed to the region of the face spaced the predetermined distance from the first tube end face, and therefore the tubular body is more firmly fixed to the face of the circuit board.

Further, an examplary embodiment includes the circuit module wherein the first tube end face is turned back from the region where the first tube end face is joined to the face of the circuit board, and is disposed at a position spaced from the face.

In this construction, the end face of the tubular body is turned back outwardly, so that the strength can be enhanced. And besides, this can also be utilized to hold a gap between it and a box body.

Further, an examplary embodiment includes the circuit module wherein the turned-back portion has a through hole extending through the portion between the first surface and the second surface.

In this construction, the through hole extending through the first surface and second surface of the turned-back portion is formed through the turned-back portion, and therefore a cavity within the turned-back portion (within the U-shaped portion), which is due to expansion of residual gas, can be eliminated, and besides the development of a convex portion formed on the upper surface of the resin by a cavity formed in the resin by gas moved from the interior of the turned-back portion into the resin and also the development of a crater-like irregularity portion formed on the upper surface of the resin portion when gas within the frame passes to the upper surface of the resin can be suppressed, and the resin portion having the smooth surface can be formed.

Further, an examplary embodiment includes the circuit module wherein the end face of the tubular body has shape of a polygon, and an extension portion is provided at the longest side of the polygon, extends from the turned-back portion, and has a first extension inner surface extending continuously at a predetermined angle relative to the first surface of the turned-back portion and a second extension outer surface opposite to the first extension inner surface.

In this construction, there is provided the extension portion which extends further from the turned-back portion and has the first extension inner surface extending continuously at the predetermined angle relative to the first surface of the turned-back portion and the second extension outer surface opposite to the first extension inner surface, and therefore the area of contact with the resin portion increases.

Further, an examplary embodiment includes the circuit module wherein the end face of the tubular body has a shape of a polygon, and an extension portion is provided at the longest side of the polygon and at the longest side and that side opposed to the longest side, extends from the turned-back portion, and has a first extension inner surface extending continuously at a predetermined angle relative to the first surface of the turned-back portion and a second extension outer surface opposite to the first extension inner surface.

In this construction, the extension portion is provided at the two opposed long sides of the polygon, so that the area of contact with the resin portion increases.

An examplary embodiment includes the circuit module wherein an extension portion is provided at the end face of the tubular body over the entire periphery thereof, and extends from the turned-back portion, and has a first extension inner surface extending continuously at a predetermined angle relative to the first surface of the turned-back portion and a second extension outer surface opposite to the first extension inner surface.
In this construction, the extension portion is provided at the end face of the tubular body over the entire periphery thereof, so that the area of contact with the resin portion further increases.

Further, an examplary embodiment includes the circuit module wherein the first surface of the turned-back portion is substantially perpendicular to the inner surface of the tubular body and the first extension inner surface of the extension portion.

With this construction, the capacity within the tubular body can be made larger, and as a result the volume of the resin portion increases, and the mechanical strength can be enhanced.

Further, an examplary embodiment includes the circuit module wherein the first surface of the turned-back portion is continuously formed to the inner surface of the tubular body and the first extension inner surface of the extension portion, and the first surface of the turned-back portion forms, together with the first extension inner surface of the extension portion, a curved surface.

With this construction, although the capacity within the tubular body decreases, gas in the interior can be more efficiently discharged, and the reduction of the residual gas can be achieved.

Further, an examplary embodiment includes the circuit module wherein the resin portion is disposed in intimate contact with the inner surface of the tubular body, the first surface of the turned-back portion, and the first extension inner surface of the extension portion.

With this construction, the area of contact with the resin portion further increases.

Further, an examplary embodiment includes the circuit module wherein the resin portion is disposed in intimate contact with the inner surface of the tubular body, the first surface of the turned-back portion and the first extension inner surface and second extension outer surface of the extension portion.

With this construction, the area of contact with the resin portion further increases.

Further, an examplary embodiment includes the circuit module wherein the resin portion is disposed in intimate contact with the inner surface of the tubular body, the first surface of the turned-back portion and the first extension inner surface of the extension portion over entire areas thereof.

Further, an examplary embodiment includes the circuit module wherein the end face of the tubular body has a shape of a polygon, and the through hole is arranged disposed at a corner of the polygon.

In this construction, the through hole is provided at the corners of the polygon which are the regions where residual gas is more liable to collect, and therefore the residual gas can be efficiently discharged.

Further, an examplary embodiment includes the circuit module wherein the through hole is disposed at a position farthermost from the face of the circuit board.

With this construction, even if the amount of filling of the resin increases, the through hole will be maintained to the end, and residual gas can be discharged more efficiently.

Further, an examplary embodiment includes the circuit module wherein the through hole is disposed at a central portion of the turned-back portion.

With this construction, the reduction of the strength of the turned-back portion due to the formation of the through hole can be kept to a minimum.

Further, an examplary embodiment includes the circuit module wherein the turned-back portion forms a partially widened region.

With this construction, the processing for meeting circuit characteristics, such as the formation of a portion (which need to be more enhanced in shielding ability) into a widened region, can be effected.

Further, an examplary embodiment includes the circuit module wherein the resin portion includes an interior of the through hole.

With this construction, even in the interior of the through hole, the joining between the resin portion and the turned-back portion is achieved, and also the mechanical strength can be increased. Incidentally, the resin portion may be formed in the whole of the through hole or may be formed in part thereof, but the larger the amount of the resin within the through hole is, the more the area of joining increases, so that the joining ability is enhanced, and also the mechanical strength increases.

Further, an examplary embodiment includes the circuit module comprising a lid member which is disposed on the tubular body, and covers an open end portion of the tubular body.

In this construction, the smoothness of the surface of the resin portion is enhanced, and therefore the cracking and destroying of the resin portion are more suppressed as compared with the case where the lid member is disposed in intimate contact with the surface of the resin portion, and there can be obtained the circuit module of a high reliability.

Further, an examplary embodiment includes the circuit module wherein the lid member is disposed in intimate contact with the second surface of the turned-back portion over the entire periphery of the open end portion of the tubular body.

With this construction, the mechanical strength is more enhanced, and the smoothness of the surface of the resin portion is enhanced, and therefore the cracking and destroying of the resin portion are more suppressed, and there can be obtained the circuit module of a high reliability.

Further, an examplary embodiment includes the circuit module wherein the lid member is disposed in intimate contact with the resin portion.

In this construction, the smoothness of the surface of the resin portion is enhanced, and therefore even when the lid member is disposed in intimate contact with the resin portion, the cracking and destroying of the resin portion are more suppressed, and there can be obtained the circuit module of a high reliability.

Further, in an examplary embodiment there is provided a circuit module comprising a board; a plurality of electronic parts mounted on a face of the board; a tubular body provided in an upstanding manner on the face of the board so as to surround the electronic parts; a face member which extends from the tubular body; an extension portion which extends from the face member; and a resin portion which intimately contacts the electronic parts within the tubular body; wherein the tubular body includes a first tube end face, a second tube end face, an inner surface and an outer surface; and the first tube end face is joined to the face of the board; and the face member includes a first face member end face, a second face member end face, a first face member side surface, a second face member side surface opposite to the first face member side surface, and a through hole extending through the portion between the first face member side surface and the second face member side surface; and the first face member end face is joined to the second tube end face; and the first face member side surface is opposed to the face of the board; and the first face member side surface is continuous with the inner surface of the tubular body; and the extension portion includes a first extension portion end face, a second extension portion end face, a first extension portion side surface, and a second extension portion side surface opposite to the first extension portion side surface; and the first extension portion end face is joined to the second face member end face; and the first extension portion side surface is arranged on a plane intersecting the face of the board; and the first extension portion side surface is continuous with the first face member side surface of the face member, and the second extension portion side surface is continuous with the second face member side surface; and the resin portion is disposed in intimate contact with the face of the board, the electronic parts, the inner surface of the tubular body, the first extension portion side surface, the second extension portion side surface and the second extension end face of the extension portion.

In this construction, the development of a cavity due to expansion of residual gas, the development of a convex portion formed on the upper surface of the resin by a cavity formed in the resin by gas moved from the interior into the resin and the development of a crater-like irregularity portion formed on the upper surface of the resin portion when gas in the interior passes to the upper surface of the resin can be suppressed.

Further, an examplary embodiment provides an electronic equipment using the circuit module.

With this construction, the compact and thin type circuit module can be formed, and therefore the compact and thin design of the portable electronic equipment can be achieved.

### ADVANTAGE OF THE INVENTION

In the above construction, the two surfaces of the resin and the turned-back portion are joined together, so that the joining strength increases, and there can be provided the circuit module which is of the thin type and has the high strength.

Furthermore, the through hole is formed at the region of the turned-back portion exposed from the resin, and therefore a cavity within the turned-back portion (within the U-shaped portion), which is due to expansion of residual gas, can be eliminated, and besides the development of a convex portion formed on the upper surface of the resin by a cavity formed in the resin by gas moved from the interior of the turned-back portion into the resin and also the development of a crater-like irregularity portion formed on the upper surface of the resin portion when gas within the frame passes to the upper surface of the resin can be suppressed.

### BRIEF DESCRIPTION OF THE DRAWINGS

Figs. 1A to 1C are views showing a circuit module according to Embodiment 1 of the present invention.
Figs. 2A to 2C are views showing a process of mounting the circuit module according to Embodiment 1 of the present invention
Figs. 3A to 3C are views showing a circuit module according to Embodiment 2 of the present invention.
Figs. 4A to 4C are views showing a circuit module according to Embodiment 3 of the present invention.
Fig. 5 is a view for explaining an advantage of the present invention.
Figs. 6A to 6F are views for explaining advantages of the present invention.
Figs. 7A to 7C are views showing a circuit module according to Embodiment 4 of the present invention.
Fig. 8 is a view showing a circuit module according to Embodiment 4 of the present invention.
Fig. 9 is a view showing a circuit module according to Embodiment 4 of the present invention.
Fig. 10 is a view showing a circuit module according to Embodiment 4 of the present invention.
Fig. 11 is a view showing an important portion of a circuit module according to Embodiment 5 of the present invention.
Fig. 12 is a view showing an important portion of a circuit module according to Embodiment 6 of the present invention.
Fig. 13 is a view showing a circuit module according to Embodiment 7 of the present invention.
Fig. 14 is a view showing a circuit module according to Embodiment 8 of the present invention.
Fig. 15 is a view showing a circuit module according to Embodiment 9 of the present invention.
Fig. 16 is a view showing a portable phone according to Embodiment 10 of the present invention.

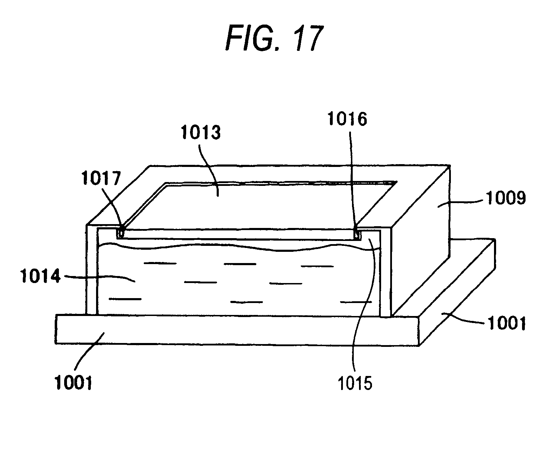

Fig. 17 is a view showing a circuit board of a conventional example.

### DESCRIPTION OF THE REFERENCE NUMERALS

1 circuit board
1 a face
2 electronic part
3 tubular body
3a inner surface
3b outer surface
4 turned-back portion
4a first surface
4b second surface
5 extension portion
5a first extension inner surface
5b second extension outer surface
5t distal end
6 resin portion
7 through hole
8 lid member
10 portable terminal
11 upper box body
12 lower box body
13 interconnecting portion
16 circuit module
19 liquid crystal display portion

### BEST MODE FOR CARRYING OUT THE INVENTION

Embodiments of the present invention will hereafter be described in detail with reference to the drawings.

### (Embodiment 1)

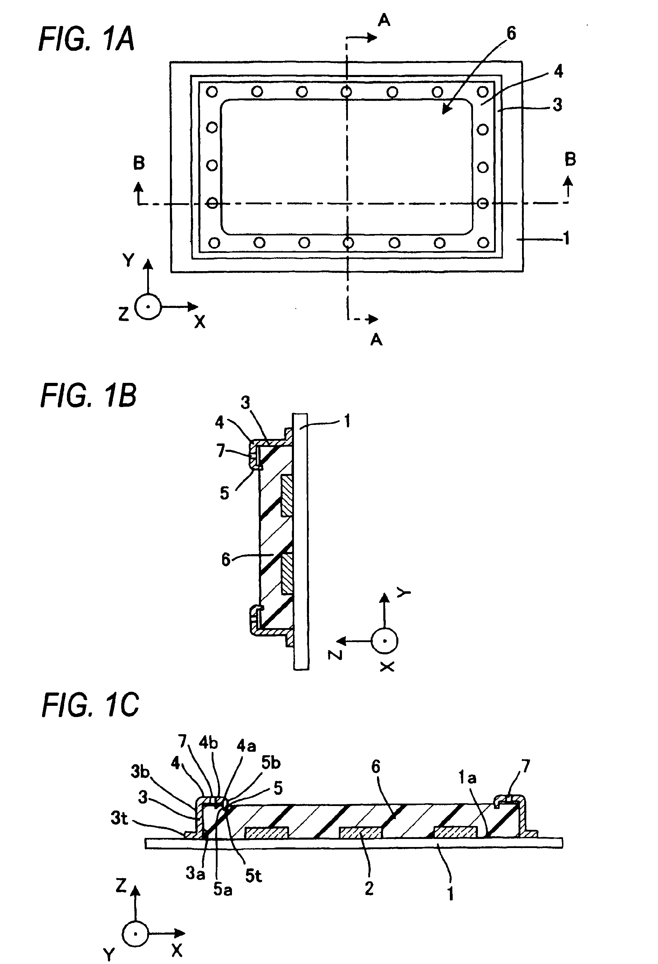

A circuit module according to Embodiment 1 of the present invention is used in a portable terminal serving as a portable electronic equipment, and is, as shown in Figs. 1A to 1C, characterized in that the circuit module includes a circuit board 1 having a wiring pattern (not shown) including at least one external connection terminal (not shown), a plurality of electronic parts 2 mounted on one face 1 a of the circuit board 1, a tubular body 3 provided in an upstanding manner on the face 1a so as to surround these electronic parts 2 such that part of an inner surface 3a of the tubular body 3 disposed near to a first tube end face 3t is joined to the face 1 a, a turned-back portion 4 which is provided at an end of the tubular body 3 opposite from the first tube end face 3t, and has a first surface 4a extending continuously from the inner surface 3a of the tubular body 3 in a direction substantially perpendicular to the inner surface 3a and a second surface 4b opposite to the first surface 4a, an extension portion 5 which extends further from this turned-back portion 4, and has a first extension inner surface 5a extending continuously in a direction substantially perpendicular to the first surface 4a of the turned-back portion 4 and a second extension outer surface 5b opposite to the first extension inner surface 5a, and a resin portion 6 formed by a sealing resin filled in the tubular body 3 to a height reaching a distal end 5t of the extension portion 5 such that it covers at least part of the electronic parts 2.

Here, the turned-back portion 4 has through holes 7 extending through the first surface 4a and the second surface 4b, and residual gas in an internal space surrounded by the inner surface 3a of the tubular body 3, the first surface 4a of the turned-back portion and the first extension inner surface 5a of the extension portion 5 can be efficiently discharged, and cavities in the resin portion and irregularities on the surface of the resin portion, which are due to expansion of the residual gas, are eliminated so that the circuit module having the resin portion with a high surface smoothness can be obtained. Here, Fig. 1A is a top plan view of this circuit module, Fig. 1B is a cross-sectional view taken along the line A-A of Fig. 1A, and Fig. 1C is a cross-sectional view taken along the line B-B of Fig. 1A.

Here, the through holes 7 are arranged at a substantially central portion of the turned-back portion 4 at predetermined intervals, and are formed such that the through holes 7 exist even at corner portions of a rectangular shape. By locating the through holes 7 at the corners, residual gas can be efficiently discharged from the corner portions where the residual gas is liable to collect. In the case where it is necessary to reduce the number of the through holes from the viewpoint of a strength, the through holes may be formed only in the corner portions.

Next, a method of the production of this circuit module will be described.

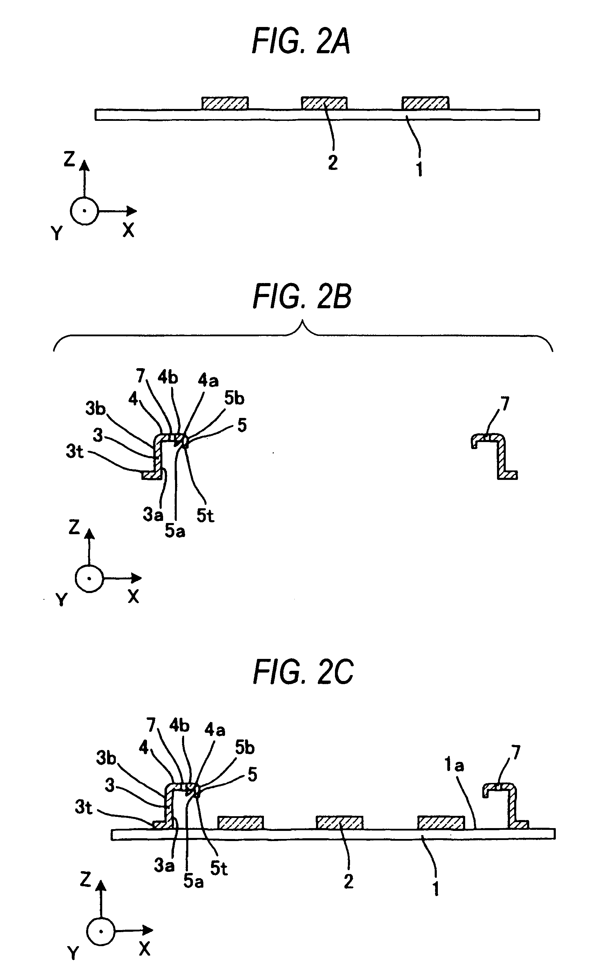

First, as shown in Fig. 2A, there is prepared a circuit board 1 comprising a printed wiring board having a desired circuit pattern (not shown) formed thereon, and electronic parts 2 are mounted on a face 1a which is a circuit pattern-forming face.

On the other hand, as shown in Fig. 2B, a tubular member having a tubular body 3, the turned-back portion 4 and an extension portion 5 is formed by pressing or the like, using a sheet-like body (made of SUS and having a sheet thickness of about 0.2 mm) as a starting material.

Then, as shown in Fig. 2C, the tubular body 3 having the turned-back portion 4 and the extension portion 5 formed integrally therewith is fixedly secured via a solder layer to the face 1a of this circuit board 1 (which is the circuit pattern-forming face) such that an end portion of an inner surface 3a of the tubular body 3 is disposed in surface contact with the face 1a.

Thereafter, a thermosetting resin such as an epoxy resin is filled as a sealing resin in such a manner that bubbles will not be generated, thereby forming a resin portion 6. Here, a thickness of the resin portion 6 is about 1.4 mm.

Thus, the circuit module shown in Fig. 1 is completed.

In this construction, the resin portion 6 composed of the sealing resin is filled in the tubular body 3 to a height reaching the distal end 5t of the extension portion 5 such that it covers the electronic parts 2, and it assumes a U-shaped configuration in the vicinity of the distal end of the tubular frame body, and the sealing resin is filled even in the interior of this U-shaped region, and the resin portion 6 is disposed in surface contact with the inner surface 3a of the tubular body 3, the first surface 4a of the turned-back portion and the first extension inner surface 5a and the second extension outer surface 5b of the extension portion 5, and this construction provides a very firm packaging form although it is of the thin type.

And besides, the tubular body 3 is provided in an upstanding manner on the face 1a such that the inner surface 3a is jointed to the region of the face 1a spaced a predetermined distance from the first tube end face 3t, and therefore the tubular body is more firmly fixed to the face of the circuit board.

Furthermore, the turned-back portion 4 has the through holes 7 extending through the first surface 4a and the second surface 4b, and therefore residual gas in the internal space surrounded by the inner surface 3a of the tubular body 3, the first surface 4a of the turned-back portion and the first extension inner surface 5a of the extension portion 5 can be efficiently discharged, and a cavity in the resin portion and irregularities on the surface of the resin portion, which are due to expansion of the residual gas, are eliminated, so that the resin portion with a high surface smoothness can be obtained. Incidentally, this tubular body and the turned-back portion and the extension portion are made of SUS, and therefore have an effect as a shielding member.

Incidentally, in the above construction, the turned-back portion corresponds to a face member, and this construction comprises the board, the plurality of electronic parts mounted on the face of the board, the tubular body provided in an upstanding manner on the face of the board in surrounding relation to the electronic parts, the face member extending from the tubular body, the extension portion extending from the face member, and the resin portion intimately contacting the electronic parts within the tubular body, and the tubular body includes the first tube end face, the second tube end face, the inner surface and an outer surface, and the first tube end face is joined to the face of the board, and the face member includes the first face member end face, the second face member end face, the first face member side surface, the second face member side surface opposite to the first face member side surface and the through holes extending through the portion between the first face member side surface and the second face member side surface, and the first face member end face is joined to the second tube end face, and the first face member side surface is opposed to the face of the board, and the first face member side surface is continuous with the inner surface of the tubular body, and the extension portion includes the first extension portion end face, the second extension portion end face, the first extension portion side surface, and the second extension portion side surface opposite to the first extension portion side surface, and the first extension portion end face is joined to the second face member end face, and the first extension portion side surface lies on a plane intersecting the face of the board, and the first extension portion side surface is continuous with the first face member side surface of the face member, and the second extension portion side surface is continuous with the second face member side surface, and the resin portion is disposed in intimate contact with the face of the board, the electronic parts, the inner surface of the tubular body, the first extension portion side surface, the second extension portion side surface and the second extension end face of the extension portion.

### (Embodiment 2)

Next, Embodiment 2 of the present invention will be described.

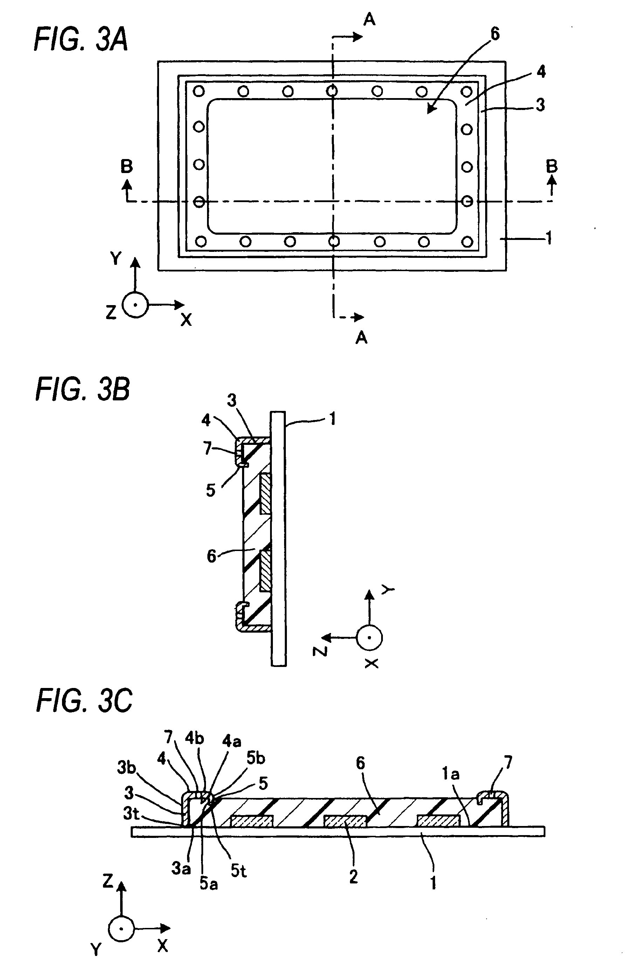

A circuit module according to Embodiment 2 of the present invention is used in a portable terminal serving as a portable electronic equipment, and differs from the above Embodiment 1 in that an end face 3t of a tubular body 3 is joined to a face 1 a of a circuit board 1 and that a sealing resin is filled in the whole of an internal space surrounded by an inner surface 3a of the tubular body 3, a first surface 4a of a turned-back portion and a first extension inner surface 5a of an extension portion 5, without forming any air cavity, as shown in Figs. 3A to 3C. With this construction, a more improved surface smoothness and a thinner design can be achieved.

Namely, it is characterized in that it comprises the circuit board 1 having at least one external connection terminal (not shown), a plurality of electronic parts 2 mounted on one face 1a of the circuit board 1, the tubular body 3 provided in an upstanding manner on the face 1a in surrounding relation to these electronic parts 2 such that the first tube end face 3t is joined to the face 1a, the turned-back portion 4 which is provided at an end of the tubular body 3 opposite from the first tube end face 3t, and has the first surface 4a extending continuously from the inner surface 3a of the tubular body 3 in a direction substantially perpendicular to the inner surface 3a and a second surface 4b opposite to the first surface 4a, the extension portion 5 which extends further from this turned-back portion 4, and has the first extension inner surface 5a extending continuously in a direction substantially perpendicular to the first surface 4a of the turned-back portion 4 and a second extension outer surface 5b opposite to the first extension inner surface 5a, and a resin portion 6 formed by the sealing resin filled in the tubular body 3 such that it covers the electronic parts 2 and covers the whole of the internal space formed by the tubular body 3, the turned-back portion 4 and the extension portion 5.

Here, also, the turned-back portion 4 has through holes 7 extending through the first surface 4a and the second surface 4b, and the sealing can be effected while efficiently discharging residual gas in the internal space surrounded by the inner surface 3a of the tubular body 3, the first surface 4a of the turned-back portion and the first extension inner surface 5a of the extension portion 5, and a cavity in the resin portion and irregularities on the surface of the resin portion, which are due to expansion of the residual gas, are eliminated so that the circuit module having the resin portion with a high surface smoothness can be obtained. Here, Fig. 3A is a top plan view of this circuit module, Fig. 3B
is a cross-sectional view taken along the line A-A of Fig. 3A, and Fig. 3C is a cross-sectional view taken along the line B-B of Fig. 1A.

Here, also, the through holes 7 are arranged at a substantially central portion of the turned-back portion 4 at predetermined intervals, and are formed such that the through holes 7 exist even at corner portions of a rectangular shape.

Furthermore, the tubular body is provided in an upstanding manner on the face of the circuit board by joining the first tube end face 3t to the face 1 a of the circuit board, and therefore an occupied area can be increased, and an electronic part-mounting area can be increased to a larger size.

As described above, in this embodiment, the compacter design and the thinner design can be achieved.

The following embodiment 3, and the corresponding Figures, is provided for illustrational purposes only.

### (Embodiment 3)

Next, Embodiment 3 will be described.

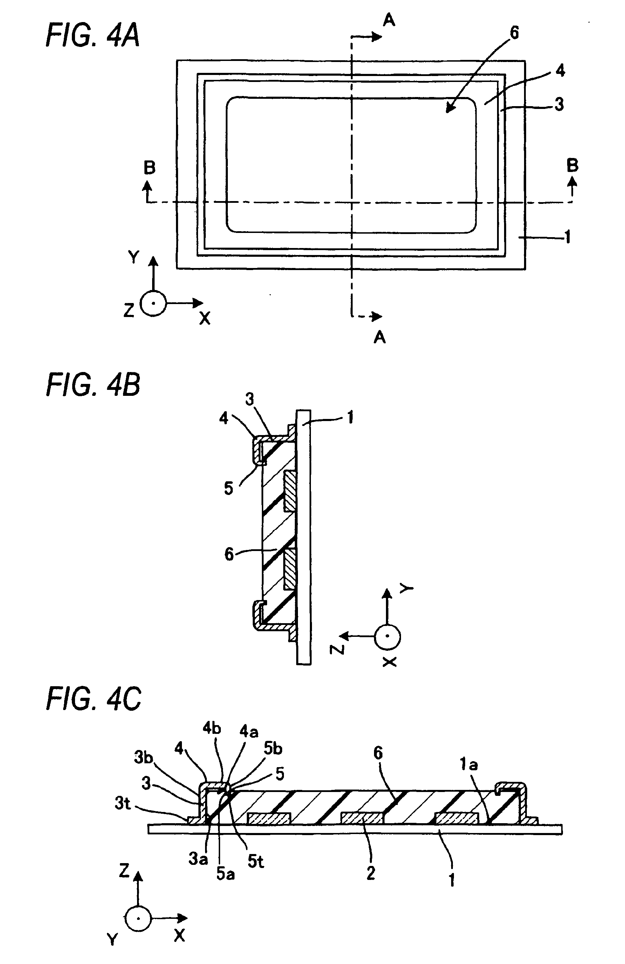

A circuit module according to Embodiment 3 is used in a portable terminal serving as a portable electronic equipment, and differs from Embodiment 1 only in that the circuit module does not have any through hole 7 as shown in Figs. 4A to 4C, and the other is formed in a similar manner.

In this construction, any through hole is not formed in a turned-back portion extending from a tubular body, and by doing so, the improvement of the strength of the turned-back portion 4 and also the improvement of the strength of the whole including the tubular body and an extension portion can be achieved. Furthermore, a magnetic shielding effect achieved by this tubular body surrounding electronic parts 2 is of course enhanced, and also a moisture resistance is enhanced since any through hole is not provided.

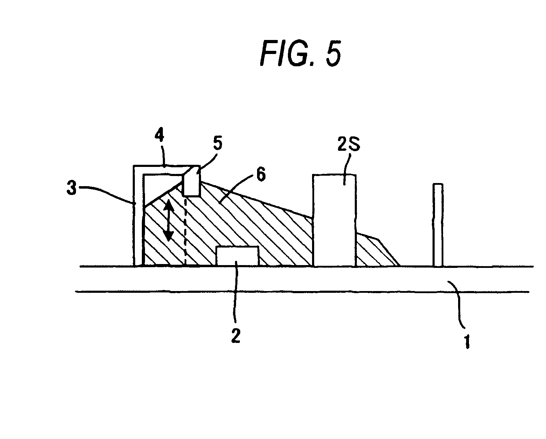

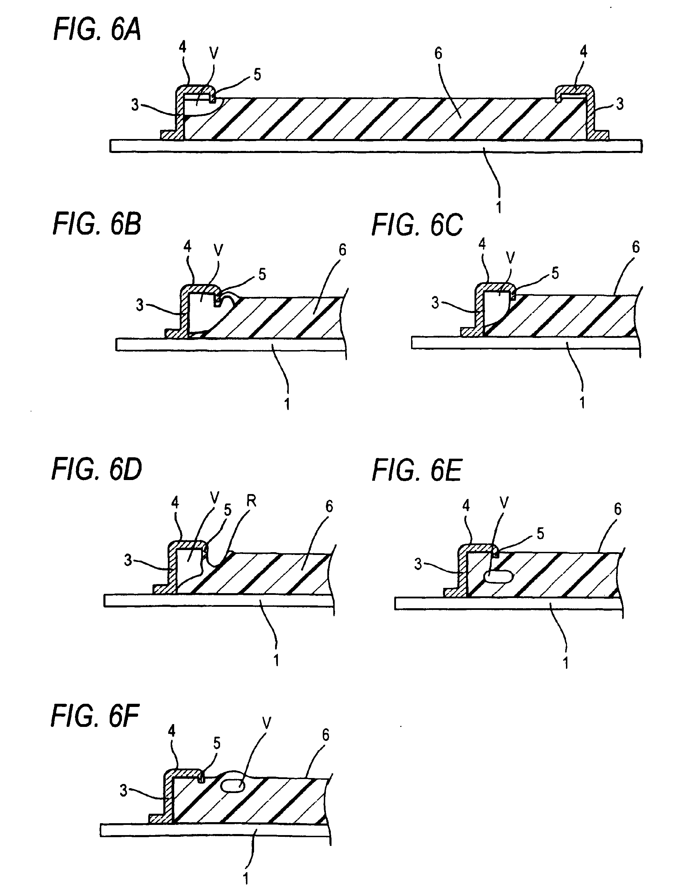

Incidentally, when filling a sealing resin, it is sometimes difficult to pour the sealing resin uniformly because of the existence of electronic parts, etc., as shown in Fig. 5, and a cavity v, an irregular portion R, etc., are formed as shown in Fig. 6A to 6F, so that it is difficult to maintain flatness of the resin surface. Fig. 6A is the case where a cavity v is formed in the vicinity of the turned-back portion 4, Figs. 6B and 6C are the case where a cavity becomes large as a result of expansion, Fig. 6D is the case where a cavity v is broken, so that an irregular portion R is formed on the surface, and Figs. 6E and 6F are the case where a cavity exists in an intermediate portion.

Such disadvantages can be substantially overcome by the formation of the through holes.

### (Embodiment 4)

Next, Embodiment 4 of the present invention will be described.

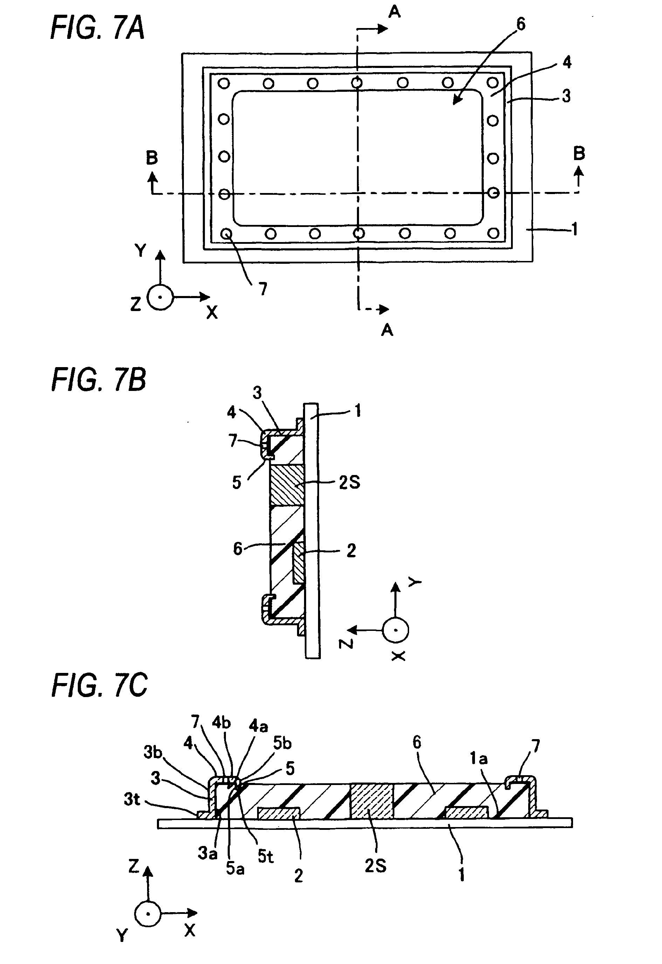

A circuit module according to Embodiment 4 of the present invention is used in a portable terminal serving as a portable electronic equipment, and in the case where electronic parts mounted on a circuit board 1 have various shapes as shown in Figs. 7A to 7C, a sealing resin is filled to form a resin portion 6 in such a manner that a top face of the highest electronic part 2S is exposed. Incidentally, through holes 7 are formed through a turned-back portion 4, and the other is formed similarly to Embodiment 1 of the present invention.

In this construction, the through holes 7 are formed in the turned-back portion extending from a tubular body, and the sealing can be effected while efficiently discharging residual gas in an internal space surrounded by an inner surface 3a of the tubular body 3, a first surface 4a of the turned-back portion 4 and a first extension inner surface 5a of an extension portion 5, and a cavity in the resin portion and irregularities on the surface of the resin portion, which are due to expansion of the residual gas, are eliminated, so that the circuit module having the resin portion with a high surface smoothness can be obtained.

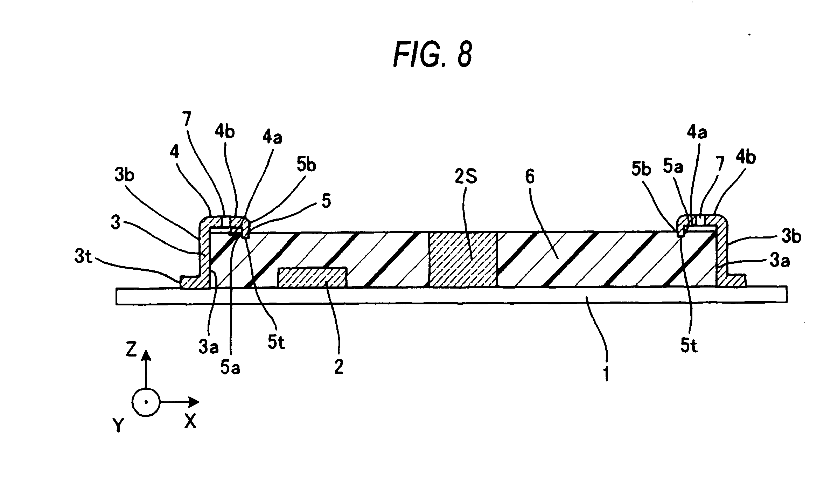

In the construction of this embodiment, also, the height of the resin portion 6 can be selected as shown in Figs. 8 to 10.

In Fig. 8, the sealing resin is filled to such a height that the internal space surrounded by the inner surface 3a of the tubular body 3, the first surface 4a of the turned-back portion 4 and the first extension inner surface 5a of the extension portion 5 remains, thus forming the resin portion 6.

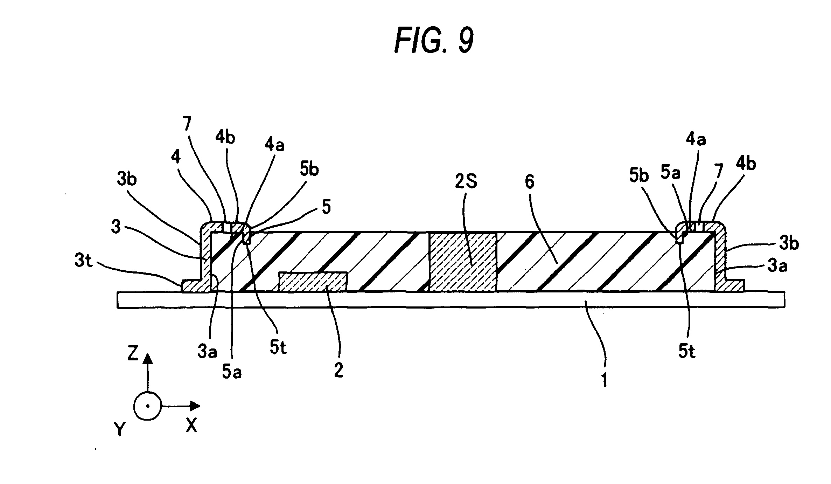

In Fig. 9, the sealing resin is filled in the whole of the internal space surrounded by the inner surface 3a of the tubular body 3, the first surface 4a of the turned-back portion 4 and the first extension inner surface 5a of the extension portion 5, thus forming the resin portion 6 with no space remaining.

With this construction, the area of contact of the inner surface 3a of the tubular body 3, the first surface 4a of the turned-back portion 4 and the first extension inner surface 5a of the extension portion 5 with the resin portion 6 is increased, so that the joining strength becomes higher.

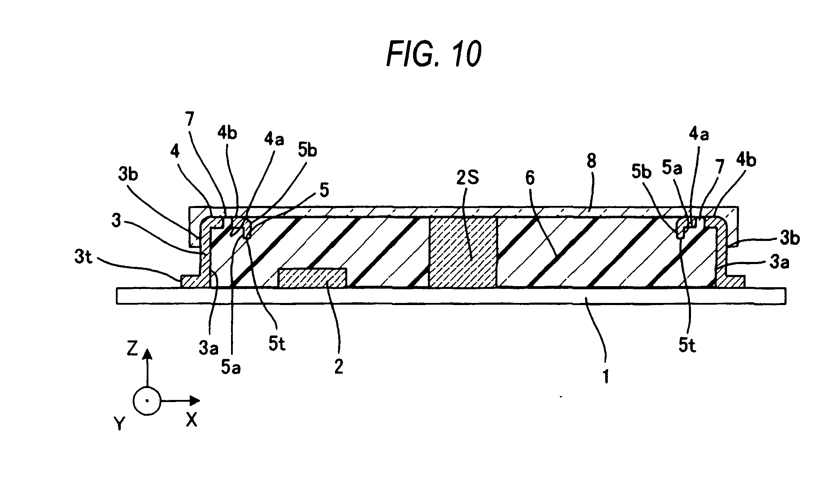

In Fig. 10, a liquid surface of the sealing resin rises into the through holes 7 so that the adhesion of the turned-back portion 4 to the resin portion is further enhanced. Here, it is formed in the through holes 7, utilizing a nature that the liquid surface rises because of a capillary phenomenon, and the liquid surface of the resin at the main surface is lower than the surface of the resin within the through hole 7. The sealing resin is filled in the whole of the internal space surrounded by the inner surface 3a of the tubular body 3, the first surface 4a of the turned-back portion 4 and the first extension inner surface 5a of the extension portion 5, thus forming the resin portion 6 with no space remaining.

In this construction, the resin is filled in the through holes 7, so that the strength of the turned-back portion 4 is increased, and besides the inner surface 3a of the tubular body 3, the first surface 4a of the turned-back portion 4 enhanced in strength, the first extension inner surface 5a of the extension portion 5 and the through holes 7 are joined to the resin portion 6, and therefore the strength can be further enhanced by a synergy effect, and the strength of the whole of the circuit module is enhanced.

### (Embodiment 5)

Next, Embodiment 5 of the present invention will be described.

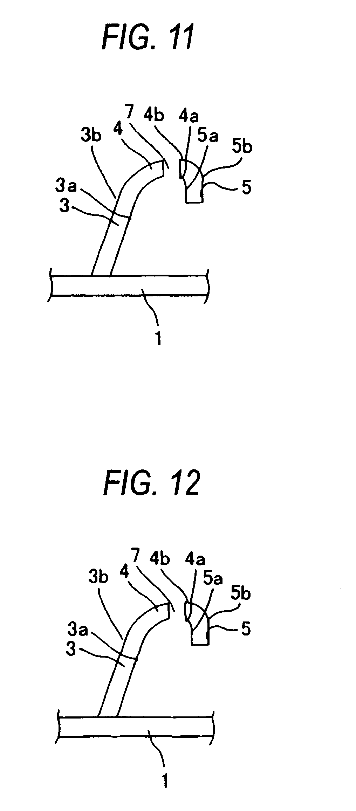

In the above embodiments, although the first surface 4a of the turned-back portion 4 is formed to be disposed substantially perpendicular to the inner surface 3a of the tubular body 3 and the first extension inner surface 5a of the extension portion 5, the first surface 4a of the turned-back portion 4 may be formed in continuous relation to the inner surface 3a of the tubular body 3 and the first extension inner surface 5a of the extension portion 5, and may form, together with the first extension inner surface 5a of the extension portion 5, a curved surface, as shown in Fig. 11 which is an explanatory view of an important portion. The other is formed similarly to Embodiment 1 of the present invention. In this case, it is preferred that through holes 7 be disposed at a position remotest from a face 1a of a circuit board 1 on which electronic parts 2 are mounted. With this arrangement, residual gas can be efficiently discharged.

### (Embodiment 6)

Next, Embodiment 6 of the present invention will be described. In this circuit module, as shown in Fig. 12 which is an explanatory view of an important portion, a tubular body 3 may be formed to be disposed at an angle of about 70 degrees relative to a face 1a of a circuit board 1, and also the first surface 4a of the turned-back portion 4 may be formed in continuous relation to an inner surface 3a of the tubular body 3 and a first extension inner surface 5a of the extension portion 5, and may form, together with the first extension inner surface 5a of the extension portion 5, a curved surface. The other is formed similarly to Embodiment 1 of the present invention.

### (Embodiment 7)

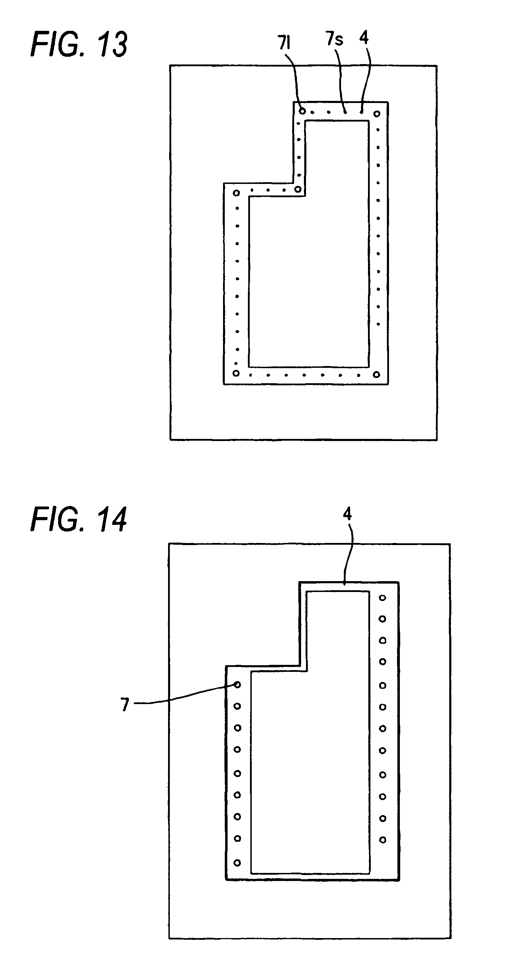

Next, Embodiment 7 of the present invention will be described. As shown in Fig. 13 which is a top plan explanatory view of this circuit module, this embodiment is characterized in that an end face of a tubular body 3 has a shape of a hexagon and that those of the through holes 7 formed respectively at corner portions of the hexagon have a large size (71), while those arranged on each side are formed as smaller through holes 7S. The other is formed similarly to the above Embodiment 1.

With this construction, the large through holes are formed through the corners at which residual gas is liable to collect, and therefore the gas can be effectively removed.

### (Embodiment 8)

Next, Embodiment 8 of the present invention will be described. As shown in Fig. 14 which is a top plan explanatory view of this circuit module, this embodiment is characterized in that an end face of a tubular body 3 forms a hexagon and that the through holes 7 are arranged at predetermined intervals on two sides of the hexagon opposed to each other. The other is formed similarly to the above Embodiment 1.

### (Embodiment 9)

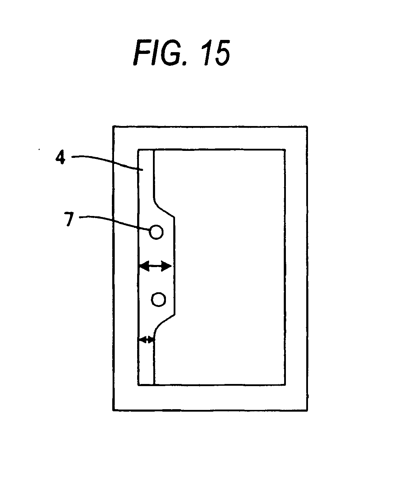

Next, Embodiment 9 of the present invention will be described. As shown in Fig. 15 which is a top plan explanatory view of this circuit module, this embodiment is characterized in that a turned-back portion 4 forms a partially widened region, and through holes 7 are arranged at this widened region. The other is formed similarly to the above Embodiment 1.

With this construction, a suction area, used at the time of mounting the tubular body, and mounting areas for other parts can be secured, and residual gas produced at this time can be effectively removed.

### (Embodiment 10)

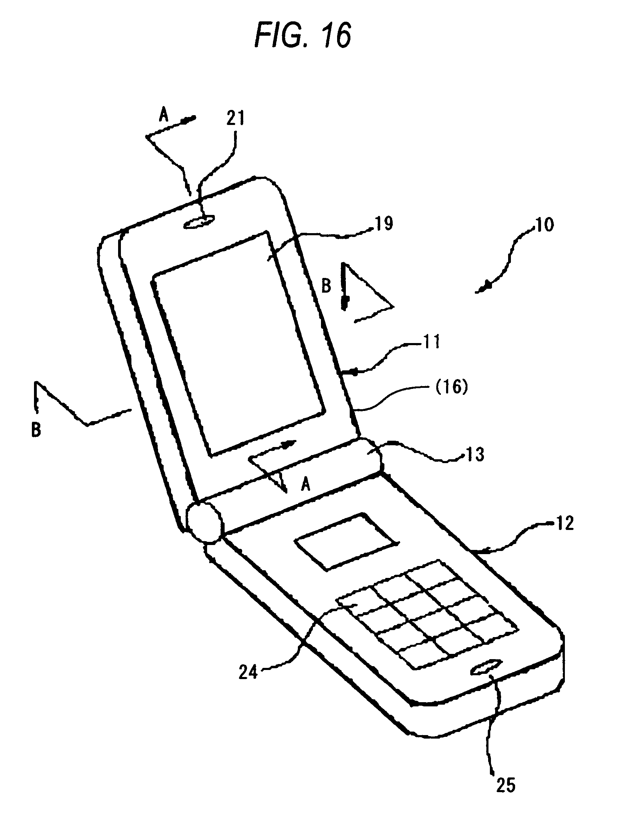

Next, Embodiment 10 of the present invention will be described. In this embodiment, a portable terminal using a circuit module of the present invention will be described. As shown in Fig. 16, the portable terminal 10 according to the embodiment of the present invention includes an upper box body 11, and a lower box body 12 pivotally connected to the upper box body 12 through an interconnecting portion 13, and is so constructed that by moving the upper box body 11 and the lower box body 12 relative to each other through the interconnecting portion 13, either of a portable condition in which the upper box body 11 and the lower box body 12 are stacked together and a usable condition (illustrated condition) in which the upper box body 11 and the lower box body 12 are spaced from each other can be selected.

Furthermore, among these, the upper box body 11 includes a front cover, and a reverse cover, and the circuit module 16 is received between the front cover and the reverse cover, and a liquid crystal display portion 19 is located on this circuit module through a lid member. 21 is an aperture for a self photographing camera, 24 is a keyboard, and 25 is an opening for an illumination sensor.

As described above, the circuit module according to the embodiment of the present invention provides the smooth surface with no cavity and irregularity existing on the surface of the resin portion, and therefore the liquid crystal display portion 19 also will not be lowered in picture quality by such irregularity at the reverse side of the liquid crystal display portion 19, and a high-quality display can be achieved.

### INDUSTRIAL APPLICABILITY

As described above, the circuit modules of the present invention are of the thin type and have the high mechanical strength, or have the high surface smoothness, and therefore can be applied the portable terminal such as a portable phone.

## Claims

1. A circuit module comprising:
a circuit board (1) which has a face (1a);
a plurality of electronic parts (2) arranged on the face of the circuit board;
a tubular body (3) provided in an upstanding manner on the face so as to surround the electronic parts;
a turned-back portion (4) turned back inwardly of the tubular body at a predetermined height position of the tubular body;
an extension portion (5) extended from the turned-back portion;
a resin portion (6) which is filled inside of the tubular body so as to cover at least a part of the electronic parts,
wherein the end face of the tubular body has a shape of a polygon;
wherein the turned-back portion and the extension portion are provided at least one of sides of the polygon; and
**characterized in that**
the turned-back portion has a through hole (7);
wherein the resin portion contacts the tubular body, the extension portion and the turned-back portion and enters into the through hole.

2. The circuit module according to claim 1, wherein
the turned-back portion is provided at one end face side of the tubular body; and
wherein a region in an inner side surface of the tubular body, extended from other end face of the tubular body toward the one end face side by a predetermined distance, is jointed to the face of the circuit board.

3. The circuit module according to claim 2, wherein
the other end face of the tubular body is turned back from the region of the tubular body which is joined to the face of the circuit board, and is disposed at a position spaced apart from the face.

4. The circuit module according to claim 1, wherein
the turned-back portion and the extension portion are provided at the longest side of the polygon.

5. The circuit module according to claim 4, wherein
the turned-back portion and the extension portion are provided at a side of the polygon opposite to the longest side of the polygon.

6. The circuit module according to claim 1, wherein
the turned-back portion and the extension portion are provided at the end face of the tubular body over the entire periphery thereof.

7. The circuit module according to claim 1, wherein
the turned-back portion is substantially perpendicular to the tubular body; and
wherein the turned-back portion is substantially perpendicular to the extension portion.

8. The circuit module according to claim 1, wherein
the tubular body, the turned-back portion and the extension portion configure a curved surface.

9. The circuit module according to claim 1, wherein
the resin portion contacts both faces of the extension portion.

10. The circuit module according to claim 1, wherein
an inner space formed by the tubular body, turned-back portion and the extension portion is entirely filled with the resin portion.

11. The circuit module according to claim 1, wherein
the through hole is disposed at a corner of the polygon.

12. The circuit module according to claim 1, wherein
the through hole is disposed at a position of the turned-back portion farthermost from the face of the circuit board.

13. The circuit module according to claim 1,
wherein the through hole is disposed at a central part of the turned-back portion.

14. The circuit module according to claim 1, wherein
the turned-back portion has a partially widened region.

15. The circuit module according to claim 1, comprising:
a lid member (8) which covers an open end portion of the tubular body.

16. The circuit module according to claim 15, wherein
the lid member contacts the turned-back portion over the entire periphery of the open end portion of the tubular body.

17. The circuit module according to claim 16, wherein
the lid member contacts the resin portion.

18. An electronic equipment equipped with the circuit module according to any one of claims 1 to 17.

## Patentansprüche

1. Schaltkreismodul, enthaltend:
eine Leiterplatte (1), die eine Fläche (1a) hat;
eine Vielzahl elektronischer Bauteile (2), die auf der Fläche der Leiterplatte angeordnet sind;
einen röhrenförmigen Körper (3), der aufrecht stehend auf der Fläche derart vorgesehen ist, dass er die elektronischen Bauteile umgibt;
einen nach innen gewandten Abschnitt (4), der in einer vorbestimmten Höhenposition des röhrenförmigen Körpers im Bezug auf den röhrenförmigen Körper nach innen gewandt ist;
einen Erweiterungsabschnitt (5), der von dem nach innen gewandten Abschnitt hervorragt;
einen Harzabschnitt (6), der derart in das Innere des röhrenförmigen Körpers gefüllt ist, dass er wenigstens einen Teil der elektronischen Bauteile bedeckt,
wobei die Stirnfläche des röhrenförmigen Körpers die Form eines Polygons hat und
der nach innen gewandte Abschnitt sowie der Erweiterungsabschnitt auf wenigstens einer Seite des Polygons vorgesehen sind; und
**dadurch gekennzeichnet, dass**
der nach innen gewandte Abschnitt ein Durchgangsloch (7) hat;
wobei der Harzabschnitt den röhrenförmigen Körper, den Erweiterungsabschnitt und den nach innen gewandten Abschnitt berührt und in das Durchgangsloch eintritt.

2. Schaltkreismodul nach Anspruch 1, bei dem der nach innen gewandte Abschnitt auf einer Stirnflächenseite des röhrenförmigen Körpers vorgesehen ist; und
ein Bereich in einer Innenseitenfläche des röhrenförmigen Körpers, der sich von der anderen Stirnfläche des röhrenförmigen Körpers zu der einen Stirnflächenseite in einem vorbestimmten Abstand erstreckt, mit der Fläche der Leiterplatte verbunden ist.

3. Schaltkreismodul nach Anspruch 2, bei dem die andere Stirnfläche des röhrenförmigen Körpers von dem Bereich des röhrenförmigen Körpers nach innen gewandt ist, der mit der Fläche der Leiterplatte verbunden ist, und in einer Position angeordnet ist, die von der Fläche beabstandet ist.

4. Schaltkreismodul nach Anspruch 1, bei dem der nach innen gewandte Abschnitt und der Erweiterungsabschnitt an der längsten Seite des Polygons vorgesehen sind.

5. Schaltkreismodul nach Anspruch 4, bei dem der nach innen gewandte Abschnitt und der Erweiterungsabschnitt an einer Seite des Polygons gegenüberliegend der längsten Seite des Polygons vorgesehen sind.

6. Schaltkreismodul nach Anspruch 1, bei dem der nach innen gewandte Abschnitt und der Erweiterungsabschnitt an der Stirnfläche des röhrenförmigen Körpers über dessen gesamten Rand vorgesehen sind.

7. Schaltkreismodul nach Anspruch 1, bei dem der nach innen gewandte Abschnitt im wesentlichen senkrecht zu dem röhrenförmigen Körper ist; und
der nach innen gewandte Abschnitt im wesentlichen senkrecht zu dem Erweiterungsabschnitt ist.

8. Schaltkreismodul nach Anspruch 1, bei dem der röhrenförmige Körper, der nach innen gewandte Abschnitt und der Erweiterungsabschnitt eine gekrümmte Oberfläche ausbilden.

9. Schaltkreismodul nach Anspruch 1, bei dem der Harzabschnitt beide Flächen des Erweiterungsabschnittes berührt.

10. Schaltkreismodul nach Anspruch 1, bei dem ein Innenraum, der durch den röhrenförmigen Körper, den nach innen gewandten Abschnitt und den Erweiterungsabschnitt ausgebildet ist, vollständig mit dem Harzabschnitt gefüllt ist.

11. Schaltkreismodul nach Anspruch 1, bei dem das Durchgangsloch an einer Ecke des Polygons angeordnet ist.

12. Schaltkreismodul nach Anspruch 1, bei dem das Durchgangsloch in einer Position des nach innen gewandten Abschnittes angeordnet ist, die am weitesten von der Fläche der Leiterplatte beabstandet ist.

13. Schaltkreismodul nach Anspruch 1, bei dem das Durchgangsloch an einem zentralen Teil des nach innen gewandten Abschnittes angeordnet ist.

14. Schaltkreismodul nach Anspruch 1, bei dem der nach innen gewandte Abschnitt einen teilweise geweiteten Bereich hat.

15. Schaltkreismodul nach Anspruch 1, enthaltend ein Deckelelement (8), das einen offenen Endabschnitt des röhrenförmigen Körpers bedeckt.

16. Schaltkreismodul nach Anspruch 15, bei dem das Deckelelement den nach innen gewandten Abschnitt über den gesamten Rand des offenen Endabschnittes des röhrenförmigen Körpers berührt.

17. Schaltkreismodul nach Anspruch 16, bei dem das Deckelelement den Harzabschnitt berührt.

18. Elektronisches Gerät, das mit dem Schaltkreismodul nach einem der Ansprüche 1 bis 17 ausgerüstet ist.

## Revendications

1. Module de circuit comprenant :
une carte à circuit imprimé (1) qui présente une face (la),
une pluralité de composants électroniques (2) disposée sur la face de la carte à circuit imprimé,
un corps tubulaire (3) prévu se dressant sur la face de façon à entourer les composants électroniques,
une partie retournée (4) qui se retourne vers l'intérieur du corps tubulaire à une hauteur prédéfinie du corps tubulaire,
une partie formant extension (5) qui s'étend depuis la partie retournée,
une partie en résine (6) qui remplit l'intérieur du corps tubulaire de façon à recouvrir au moins une partie des composants électroniques,
dans lequel la face de l'extrémité du corps tubulaire présente la forme d'un polygone,
dans lequel la partie retournée et la partie formant extension sont prévues sur au moins l'un des côtés du polygone, et
**caractérisé en ce que**
la partie retournée comporte un trou traversant (7),
dans lequel la partie de résine est en contact avec le corps tubulaire, la partie formant extension et la partie retournée et rentre dans le trou traversant.

2. Module de circuit selon la revendication 1, dans lequel
la partie retournée est prévue au niveau d'une face de l'extrémité du corps tubulaire, et
dans lequel une zone située dans une surface interne du corps tubulaire, s'étendant depuis l'autre face d'extrémité du corps tubulaire vers la première face d'extrémité d'une distance prédéfinie, est reliée à la face de la carte à circuit imprimé.

3. Module de circuit selon la revendication 2, dans lequel
l'autre face d'extrémité du corps tubulaire se retourne depuis la zone du corps tubulaire qui est reliée à la face de la carte à circuit imprimé, et elle est espacée de la face.

4. Module de circuit selon la revendication 1, dans lequel
la partie retournée et la partie formant extension sont prévues du côté le plus long du polygone.

5. Module de circuit selon la revendication 4, dans lequel
la partie retournée et la partie formant extension sont prévues sur un côté du polygone opposé au côté le plus long du polygone.

6. Module de circuit selon la revendication 1, dans lequel
la partie retournée et la partie formant extension sont prévues au niveau de la face de l'extrémité du corps tubulaire sur la périphérie entière de celui-ci.

7. Module de circuit selon la revendication 1, dans lequel
la partie retournée est sensiblement perpendiculaire au corps tubulaire, et
dans lequel la partie retournée est sensiblement perpendiculaire à la partie formant extension.

8. Module de circuit selon la revendication 1, dans lequel
le corps tubulaire, la partie retournée et la partie formant extension établissent la configuration d'une surface courbe.

9. Module de circuit selon la revendication 1, dans lequel
la partie en résine est en contact avec les deux faces de la partie formant extension.

10. Module de circuit selon la revendication 1, dans lequel
un espace interne, formé par le corps tubulaire, la partie retournée et la partie formant extension est entièrement rempli par la partie en résine.

11. Module de circuit selon la revendication 1, dans lequel
le trou traversant est placé à un coin du polygone.

12. Module de circuit selon la revendication 1, dans lequel
le trou traversant est placé à une position de la partie retournée la plus éloignée de la face de la carte à circuit imprimé.

13. Module de circuit selon la revendication 1,
dans lequel le trou traversant est placé à une partie centrale de la partie retournée.

14. Module de circuit selon la revendication 1, dans lequel
la partie retournée comporte une zone partiellement élargie.

15. Module de circuit selon la revendication 1, comprenant :
un élément formant couvercle (8) qui recouvre et ouvre la partie d'extrémité du corps tubulaire.

16. Module de circuit selon la revendication 15, dans lequel
l'élément formant couvercle est en contact avec la partie retournée sur la périphérie entière de la partie d'extrémité ouverte du corps tubulaire.

17. Module de circuit selon la revendication 16, dans lequel
l'élément formant couvercle entre en contact avec la partie en résine.

18. Équipement électronique muni du module de circuit conforme à l'une quelconque des revendications 1 à 17.
